# EUROPEAN PATENT APPLICATION

(11) **EP 4 213 176 A1**
(43) Date of publication of application: **19.07.2023**
(21) Application number: 22151364.1
(22) Date of filing: 13.01.2022
(51) Int. Cl.: H01J 37/244, H01J 37/28

(54) **CHARGED PARTICLE ASSESSMENT SYSTEM**

(71) Applicant: ASML Netherlands B.V., 5500 AH Veldhoven (NL)
(72) Inventor: VAN SOEST, Jurgen, 5500 AH Veldhoven (NL); KUIPER, Vincent, Sylvester, 5500 AH Veldhoven (NL); LI, Yinglong, San Jose, 95134 (US)
(74) Representative: ASML Netherlands B.V.

(57) **Abstract**

A charged particle assessment apparatus comprising: a charged particle beam device; an actuated sample stage; a hot component and a thermal compensator. The actuated sample stage is configured to hold a sample. The hot component is configured to operate such that, during operation, heat is radiated toward a sample held on the sample holder. The hot component is smaller than the sample. The thermal compensator is configured to heat the sample so as to reduce thermal gradients therein.

## Description

### FIELD

The embodiments provided herein generally relate to charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection apparatuses with a charged particle beam have been used to inspect objects, which may be referred to as samples, for example to detect pattern defects. These apparatuses typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons (or signal particles) from the sample surface, a pattern inspection apparatus may obtain an image representing characteristics of the material structure of the surface of the sample.

When a pattern inspection apparatus is used to detect defects on samples at a high throughput, a large amount of power is dissipated in the apparatus by various sources. Localized heat sources can cause thermal gradients in the pattern inspection apparatus which are undesirable for various reasons. In particular, thermal gradients can cause dimensional shifts and variations in parts of the pattern inspection apparatus and/or the sample being inspected.

### SUMMARY

It is an object of the present disclosure to provide embodiments that reduce or ameliorate deleterious effects of localized heat sources in a pattern inspection apparatus.

According to a first aspect of the invention, there is provided a charged particle assessment apparatus comprising: a charged particle beam device; an actuated sample stage configured to hold a sample; a hot component configured to operate such that, during operation, heat is radiated toward a sample held on the sample holder, the hot component being smaller than the sample; and a thermal compensator configured to heat the sample so as to reduce thermal gradients therein.

According to a second aspect of the invention there is provided a method of assessing samples using a charged particle beam apparatus, the method comprising: scanning a sample held on an actuated sample stage relative to a charged particle beam and detecting charged particles returning from the sample, wherein a hot component of the charged particle beam system radiates heat locally to the sample during the scanning; and heating the substrate to reduce thermal gradients therein.

According to a third aspect of the invention there is provided a method of loading a sample into a charged particle beam apparatus, the method comprising: heating a sample prior to the sample being supported by a sample support of the charged particle beam apparatus; loading the sample onto the sample support; and maintaining the temperature of the sample above a threshold temperature during the

According to fourth aspect of the invention there is provided a particle assessment apparatus comprising: a particle beam device; an actuated sample support configured to support a sample; a hot component that is configured to radiate heat toward a sample supported on the sample support during operation of the system; a thermal compensator proximate the particle beam device and configured to direct heat towards the sample so as to reduce thermal gradients therein generated by a thermally elevated component; a heating device configured to heat the sample before the sample is supported by the sample support; and a controller configured to control at least the thermal compensator and the heating device so that the temperature of the thermal compensator is at least maintained above a threshold temperature while the sample is loaded, desirably clamped, onto the sample support.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection system.
**FIG. 2** is a schematic diagram illustrating an exemplary multi-beam charged particle assessment apparatus that is part of the exemplary charged particle beam inspection system of **FIG. 1****.**
**FIG. 3** is a schematic diagram of an exemplary electron-optical device comprising a condenser lens array.
**FIG. 4** is a schematic diagram of an exemplary electron-optical device comprising a macro collimator and macro scan deflector.
**FIG. 5** is a schematic diagram of an exemplary electron-optical device comprising a beam separator.
**FIG. 6** is a schematic cross-sectional view of an objective lens array of a charged particle assessment system according to an embodiment.
**FIG. 7** is a bottom view of a modification of the objective lens array of **FIG. 7****.**
**FIG. 8** is a schematic diagram of an exemplary single beam electron-optical device.
**FIG. 9** is a schematic diagram of a part of an exemplary electron-optical device having a localized heat source.
**FIG. 10** is a schematic diagram of a part of an electron-optical device having a thermal compensator in a lower part of the electron-optical device.
**FIG. 11** is a schematic diagram of a part of an electron-optical device having a thermal compensator formed as part of a high voltage plate.
**FIG. 12** is a schematic diagram of a part of a charged particle assessment apparatus having multiple electron-optical devices and a thermal compensator.
**FIG. 13** is a schematic diagram of a part of an electron-optical device having a thermal compensator in a sample load path.
The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

A SEM comprises a scanning device and a detector. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical column or device. The primary electrons interact with the sample and generate secondary electrons. The detector captures the secondary electrons from the sample as the sample is scanned so that the SEM can create an image of the scanned area of the sample. The detector may be part of the electron-optical column or device. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

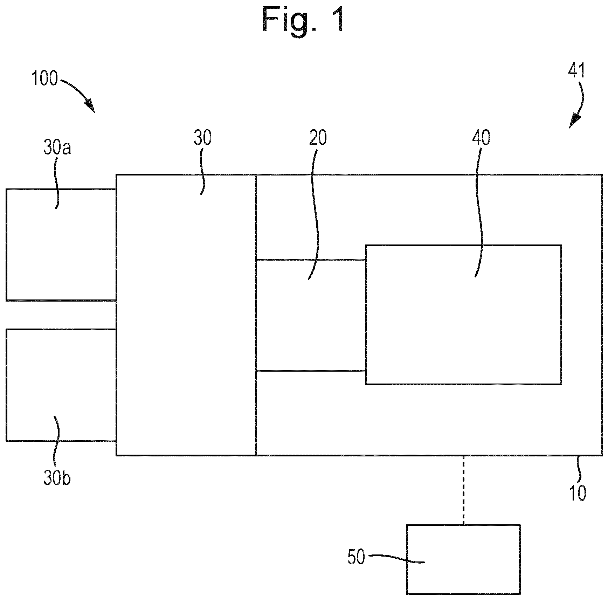

Reference is now made to **FIG. 1****,** which is a schematic diagram illustrating an exemplary charged particle beam inspection system 100, which may also be referred to as a charged particle beam assessment system or simply assessment system. The charged particle beam inspection system100 of **FIG. 1** includes a main chamber 10, a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus.

The controller 50 is electronically connected to electron beam system 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure.

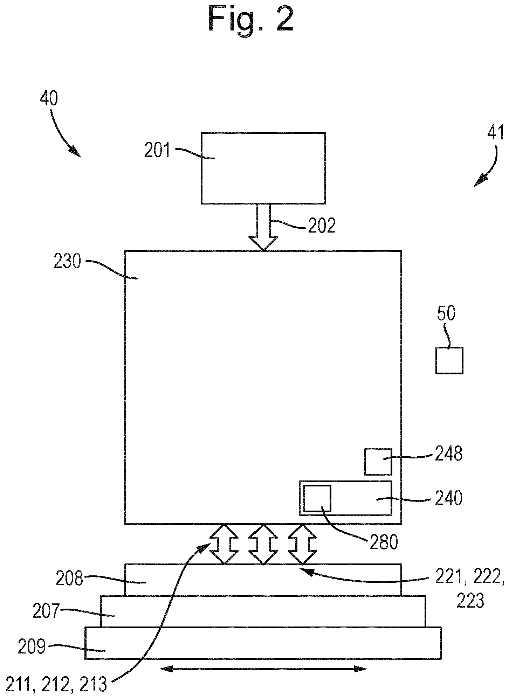

Reference is now made to **FIG. 2****,** which is a schematic diagram illustrating an exemplary electron beam system 40, including a multi-beam electron-optical device 41, that is part of the exemplary charged particle beam inspection system 100 of **FIG. 1****.** The electron beam system 40 comprises an electron source 201 and a projection apparatus 230. The electron beam system 40 further comprises a actuated stage 209 and a sample holder 207 (which may also be referred to as a sample support). The electron source 201 and projection apparatus 230 may together be referred to as the electron-optical device 41. The sample holder 207 is supported by actuated stage 209 so as to hold a sample 208 (e.g., a substrate or a mask) for inspection. The multi-beam electron-optical device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands, many tens of thousands or many hundreds of thousands of sub-beams. The sub-beams may be referred to as beamlets.

The controller 50 may be connected to various parts of the charged particle beam inspection apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the electron beam system 40 such as the detector 240 (as shown in **FIG. 2**). However, the signal processing system 280 may be incorporated into any number of components of the inspection apparatus 100 or electron beam system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof.

The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample. The above functions of the signal processing system 280 may be carried out in the controller 50 or shared between the signal processing systems 280 and controller 50 as convenient.

The controller 50 may control the actuated stage 209 to move sample 208 during inspection of the sample 208. The controller 50 may enable the actuated stage 209 to move the sample 208 in a direction, desirably continuously, for example at a constant speed, at least during sample inspection, which may be referred to as a type of scanning. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process and/or scans of the scanning process for example as disclosed in EPA 21171877.0 filed 3 May 2021 which is hereby incorporated in so far as the combined stepping and scanning strategy at least of the stage.

Known multi-beam systems, such as the electron beam system 40 and charged particle beam inspection apparatus 100 described above, are disclosed in US2020118784, US20200203116, US 2019/0259570 and US2019/0259564 which are hereby incorporated by reference.

The electron beam system 40 may comprise a projection assembly to regulate accumulated charges on the sample by illuminating the sample 208.

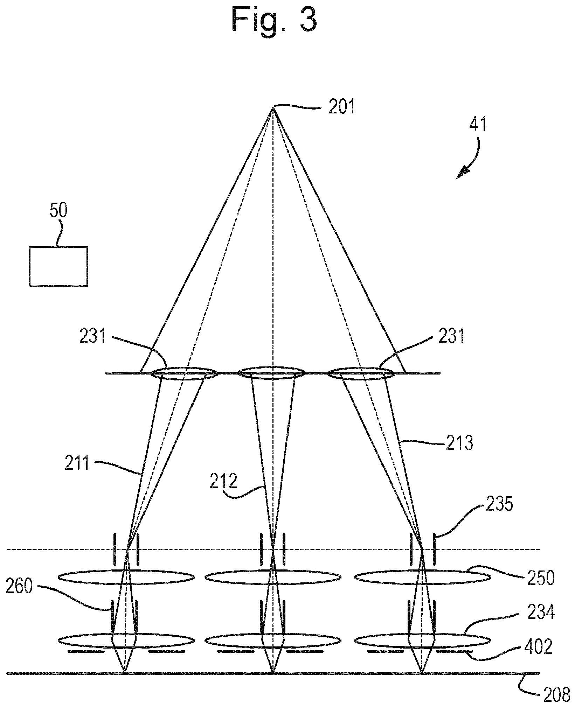

**FIG. 3** is a schematic diagram of an exemplary electron-optical device 41 for use in an assessment system. The electron-optical column, or device, may comprise a plurality of electron-optical elements arranged along the paths of the sub-beams 211, 212, 213. Such electron-optical elements may comprise, in a non-limited list: a lens such as a lens array, a collimator such as a collimator array, correctors for example as corrector arrays and a detector such as a detector array. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle arrangements such as those discussed herein, it will be understood however that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along sub-beam paths of sub-beams of a multi-beam.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an electron beam into a plurality of sub-beams, with the array providing a lens for each sub-beam. The array of condenser lenses 231 may take the form of at least two plates, desirably three, acting as electrodes, with an aperture in each plate aligned with each other and corresponding to the location of a sub-beam. At least two of the plates are maintained during operation at different potentials to achieve the desired lensing effect. Between the plates of the condenser lens array are electrically insulating plates for example made of an insulating material such as ceramic or glass, with one or more apertures for the sub-beams. An alternative arrangement one more of the plates may feature apertures each with their own electrode, each with an array of electrodes around their perimeter or arranged in groups of apertures having a common electrode.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. A collimator or an array of collimators may be positioned to operate on the respective intermediate focus 233. The collimators may take the form of deflectors 235 provided at the intermediate focuses 233. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample ).

Below (i.e. down-beam of or further from source 201) deflectors 235 there is a control lens array 250 comprising a control lens 251 for each sub-beam 211, 212, 213. Control lens array 250 may comprise two or more, desirably at least three, plate electrode arrays connected to respective potential sources, desirably with insulating plates in contact with the electrodes for example between the electrodes. Each of the plate electrode arrays may be referred to as a control electrode. A function of control lens array 250 is to optimize the beam opening angle with respect to the demagnification of the beam and/or to control the beam energy delivered to the objective lenses 234, each of which directs a respective sub-beam 211, 212, 213 onto the sample 208. In an alternative terminology, the control lens array may be considered a lens array associated with the objective lens array. The plates comprising the control lens array may be plates associated with and proximate to the plates of the objective lens array. Each of these plates (e.g. electrodes) may provide an additional degree of freedom with which to control the electron-optical characteristics of the sub-beans.

Optionally an array of scan deflectors 260 is provided between the control lens array 250 and the array of objective lenses 234 (objective lens array). The array of scan deflectors 260 comprises a scan deflector 261 for each sub-beam 211, 212, 213. Each scan deflector is configured to deflect a respective sub-beam 211, 212, 213 in one or two directions so as to scan the sub-beam across the sample 208 in one or two directions.

A detector module 240 of a detector is provided within or between the objective lenses 234 and the sample 208 to detect signal electrons/ particles emitted from the sample 208. An exemplary construction of such a detector module 240 is described below. Note that the detector additionally or alternative may have detector elements up-beam along the primary beam path of the objective lens array or even the control lens array.

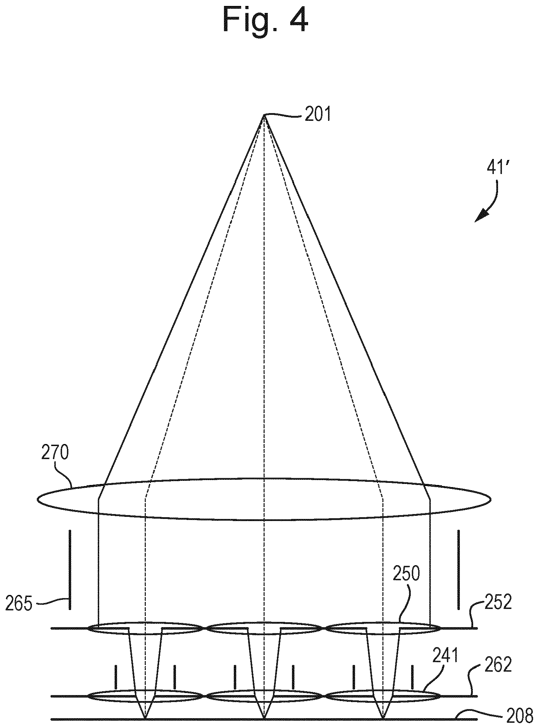

**FIG. 4** is a schematic diagram of an exemplary electron beam system having an alternative electron-optical device 41'. The electron-optical device 41' comprises an objective lens array 241. The objective lens array 241 comprises a plurality of objective lenses. The objective lens array 241 may be an exchangeable module. For conciseness, features of the electron beam system that have already been described above may not be repeated here.

As shown in **FIG. 4****,** the electron-optical device 41' comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The beam may separate into the sub-beams on meeting the control lens array 250. The sub-beams are substantially parallel on entry to the control lens array 250. The sub-beams of the multi-beam may be arranged in a pattern which may be referred to as a multi-beam arrangement. The pattern may form a grid. The grid may be hexagonal, rectilinear, rhombic or square. In the example shown, a collimator is provided up-beam of the objective lens array assembly.

The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 comprises a magnetic lens and/or an electrostatic lens. In another arrangement (not shown), the macro-collimator may be partially or wholly replaced by a collimator element array provided down-beam of the upper beam limiter.

In the electron-optical device 41' of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250. In another arrangement (not shown), the macro scan deflector 265 may be partially or wholly replaced by a scan deflector array, for example as a scan deflector for each sub-beam. In other embodiments both a macro scan deflector 265 and the scan-deflector array are provided, and they may operate in synchronization.

In some embodiments, the electron-optical device 41 further comprises an upper beam limiter 252. The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

In some embodiments, as exemplified in **FIG. 4****,** the objective lens array assembly (which is a unit that comprises the objective lens array 241) further comprises a beam shaping limiter 262. The beam shaping limiter 262 defines an array of beam-limiting apertures. The beam shaping limiter 262 may be referred to as a lower beam limiter, lower beam-limiting aperture array or final beam-limiting aperture array. The beam shaping limiter 262 may comprise a plate (which may be a plate-like body) having a plurality of apertures. The beam shaping limiter 262 may be down-beam from at least one electrode (optionally from all electrodes) of the control lens array 250. In some embodiments, the beam shaping limiter 262 is down-beam from at least one electrode (optionally from all electrodes) of the objective lens array 241. In an arrangement, the beam shaping limiter 262 is structurally integrated with an electrode of the objective lens array 241. Desirably, the beam shaping limiter 262 is positioned in a region of low electrostatic field strength. The alignment of the beam-limiting apertures with the objective lens array is such that a portion of a sub-beam from the corresponding objective lens can pass through the beam-limiting aperture and impinge onto the sample 208, so that only a selected portion of the sub-beam incident onto the beam shaping limiter 262 to pass through the beam-limiting aperture.

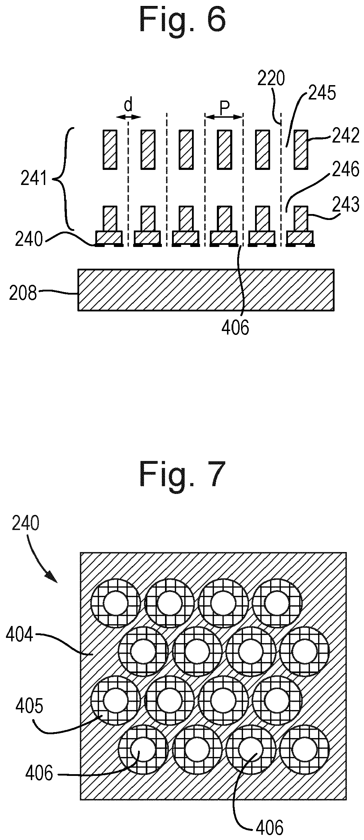

Any of the objective lens array assemblies described herein may further comprise a detector 240. Alternatively the detector may be structurally separate from the objective lens array assembly. The detector detects signal particles, such as electrons, emitted from the sample 208. The detected signal particles may include any of the types of electrons ordinarily detected by a SEM, such as secondary and/or backscattered electrons emitted from the sample 208. An exemplary construction of a detector 240 is described in more detail below with reference to **FIGs. 6** and **7****.**

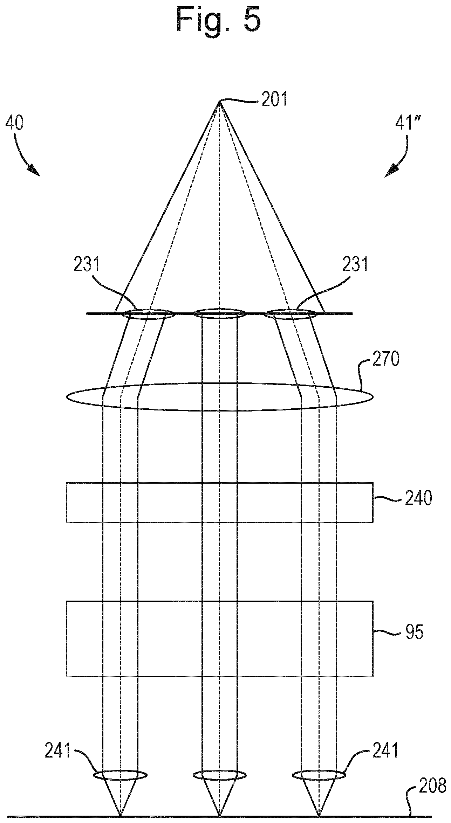

**FIG. 5** schematically depicts an electron beam system 40 including an electron-optical device 41" (or electron-optical device 41") according to an embodiment. Features that are the same as those described above are given the same reference numerals. For conciseness, such features are not described in detail with reference to **FIG. 5****.** For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208. A surface of an electrode the objective lens array may face a position of the sample during operation. That is, a most down-beam surface of the objective lens array may face a surface of the sample when the sample is in position.

In an embodiment a deflector array 95 is between the detector 240 and the objective lens array 241. In an embodiment the deflector array 95 comprises a Wien filter array so that deflector array may be referred to as a beam separator. The deflector array 95 is configured to provide a magnetic field to disentangle the charged particles projected to the sample 208 apart from the secondary electrons from the sample 208 towards the detector 240.

In an embodiment the detector 240 is configured to detect signal particles by reference to the energy of the charged particle, i.e. dependent on a band gap. Such a detector 240 may be called an indirect current detector. The secondary electrons emitted from the sample 208 gain energy from the fields between the electrodes. The secondary electrodes have sufficient energy once they reach the detector 240. In a different arrangement the detector 240 may be a scintillator array of for example of fluorescing strips between the beams and that are positioned up beam along the primary beam path with respect to the Wien filter. Primary beams passing through the Wien filter array (of magnetic and electrostatic strips orthogonal to the primary beam path) have paths up beam and down-beam of the Wien filter array that substantially parallel; whereas signal electrons from the sample are directed to the Wien filter array towards the scintillator array. The generated photons are directed via a photon transport unit (e.g. an array of optical fibers) to a remote optical detector which generates a detection signal on detection of a photon

The objective lens array 241 of any embodiment may comprise at least two electrodes in which are defined aperture arrays. In other words, the objective lens array comprises at least two electrodes with a plurality of holes or apertures. **FIG. 6** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 6****,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an incoming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than an objective lens of the objective lens array.

Desirably, each of the electrodes provided in the objective lens array 241 is a plate. The electrode may otherwise be described as a flat sheet. Desirably, each of the electrodes is planar. In other words, each of the electrodes will desirably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

A detector 240 is provided to detect signal particles, i.e. secondary and/or backscattered charged particles, emitted from the sample 208. The detector 240 is positioned between the objective lenses 234 and the sample 208. On detection of a signal particle the detector generates a detection signal. The detector 240 may otherwise be referred to as a detector array or a sensor array, and the terms "detector" and "sensor" are used interchangeably throughout the application.

An electron-optical device for the electron-optical device 41 may be provided. The electron-optical device is configured to project a beam of electrons towards the sample 208. The electron-optical device may comprise the objective lens array 241. The electron-optical device may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIG. 7****.**

The detector 240 may be positioned between the objective lens array 241 and the sample 208. The detector 240 is configured to be proximate the sample 208. The detector 240 may be very close to the sample 208. Alternatively, there may be a larger gap from the detector 240 to the sample 208. The detector 240 may be positioned in the device so as to face the sample 208. Alternatively, the detector 240 may be positioned elsewhere in the electron-optical device 41 such that part of the electron-optical device that is not a detector faces the sample 208.

**FIG. 7** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 7****,** the beam apertures 406 are in a hexagonal close packed array. The beam apertures 406 can also be differently arranged, e.g. in a rectangular, or a rhombic, array. The beam arrangement of the hexagonal arrangement in **FIG. 7** may be more densely packed than a square beam arrangement. The detector elements 405 may be arranged in a rectangular array or a hexagonal array. The beam apertures may correspond to the multi-beam arrangement of the sub-beams towards the substrate 404.

Capture electrodes 405 form the bottommost, i.e. most close to the sample, surface of the detector module 240. Between the capture electrodes 405 and the main body of the silicon substrate 404 a logic layer is provided. Logic layer may include amplifiers, e.g. Trans Impedance Amplifiers, analogue to digital converters, and readout logic. In an embodiment, there is one amplifier and one analogue to digital converter per capture electrode 405. A circuit featuring these elements may be comprised in a unit area referred to as a cell that is associated with an aperture. The detector model 240 may have several cells each associated with an aperture.

Within or on the substrate is a wiring layer connected to the logic layer and externally connecting the logic layer of each cell for example via power, control and data lines. The integrated detector module 240 described above is particularly advantageous when used with a system having tunable landing energy as secondary electron capture can be optimized for a range of landing energies. A detector module in the form of an array can also be integrated into other electrode arrays, not only the lowest electrode array. Such a detector module may feature detectors that are scintillators or semiconductor detectors such as PIN detectors, for example above the down-beam most surface of the objective lens. Such detector modules may feature a similar circuit architecture as a detector module comprising a current detector. Further details and alternative arrangements of a detector module integrated into an objective lens can be found in EP Application Numbers 20184160.8 and 20217152.6, which document is hereby incorporated by reference at least so far as details of the detector module.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406, which provides an examples of such a detector. As mentioned the detection signal from the detector module is used to generate an image. With multiple detecting portions, the detection signal comprises components from the different detecting signals that may be processed as data sets or in a detection image.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the system and can be swapped between operable and non-operable positions without opening the electron beam system.

In some embodiments, one or more aberration correctors are provided that reduce one or more aberrations in the sub-beams. Aberration correctors positioned in, or directly adjacent to, the intermediate foci (or intermediate image plane) may comprise deflectors to correct for the source 201 appearing to be at different positions for different beams. Correctors can be used to correct macroscopic aberrations resulting from the source that prevent a good alignment between each sub-beam and a corresponding objective lens. Aberration correctors may correct aberrations that prevent a proper column alignment. Aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. Aberration correctors may reduce one or more of the following: field curvature; focus error; and astigmatism.

The invention can be applied to various different system architectures. For example, the electron beam system may be a single beam system, or may comprise a plurality of single beam columns or may comprise a plurality of columns of multi-beams. The columns may comprise the electron-optical device 41 described in any of the above embodiments or aspects. As a plurality of columns (or a multi-column system), the devices may be arranged in an array which may number two to one hundred columns or more. The electron beam system may take the form of an embodiment as described with respect to and depicted in **FIG. 3** or as described with respect to and depicted in **FIG. 4****,** although desirably having an electrostatic scan deflector array and an electrostatic collimator array.

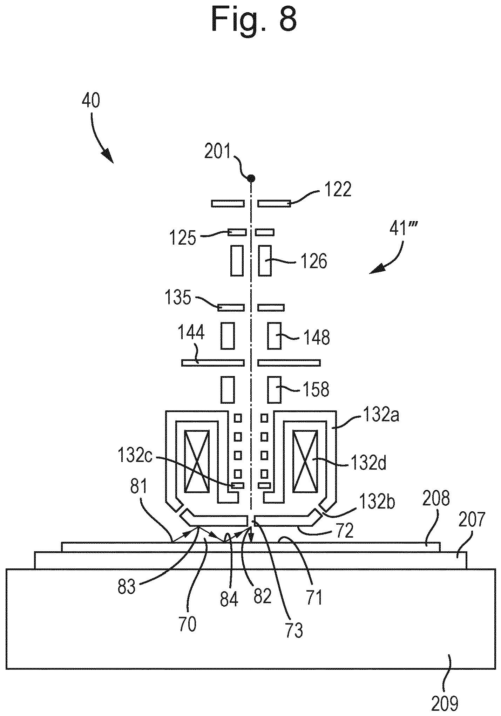

**FIG. 8** is a schematic diagram of an exemplary single beam electron beam system 41'" according to an embodiment. As shown in **FIG. 8****,** in an embodiment the electron beam system comprises a sample holder 207 supported by an actuated stage 209 to hold a sample 208 to be inspected. The electron beam system comprises an electron source 201. The electron beam system further comprises a gun aperture 122, a beam limit aperture 125, a condenser lens 126, a column aperture 135, an objective lens assembly 132, and an electron detector 144. The objective lens assembly 132, in some embodiments, may be a modified swing objective retarding immersion lens (SORIL), which includes a pole piece 132a, a control electrode 132b, a deflector 132c, and an exciting coil 132d. The control electrode 132b has an aperture formed in it for the passage of the electron beam. The control electrode 132b forms the facing surface 72, described in more detail below.

In an imaging process, an electron beam emanating from the source 201 may pass through the gun aperture 122, the beam limit aperture 125, the condenser lens 126, and be focused into a probe spot by the modified SORIL lens and then impinge onto the surface of sample 208. The probe spot may be scanned across the surface of the sample 208 by the deflector 132c or other deflectors in the SORIL lens. Secondary electrons emanated from the sample surface may be collected by the electron detector 144 to form an image of an area of interest on the sample 208.

The condenser and illumination optics of the electron-optical device 41 may comprise or be supplemented by electromagnetic quadrupole electron lenses. For example, as shown in **FIG. 8** the electron-optical device 41 may comprise a first quadrupole lens 148 and a second quadrupole lens 158. In an embodiment, the quadrupole lenses are used for controlling the electron beam. For example, first quadrupole lens 148 can be controlled to adjust the beam current and second quadrupole lens 158 can be controlled to adjust the beam spot size and beam shape.

Various approaches may be taken to detect defects in images generated by a charged particle assessment device. A particularly suitable test usable is to compare an image of a part of the sample, referred to herein as a sample image, to a reference image. In practice, data points of a datastream representing the sample image are compared to data points of the reference image retrieved from a memory or delivered in a parallel data stream. For the sake of brevity, this process may be referred to below as comparing images and the data points as pixels. Any pixel that differs from the corresponding pixel of the reference image may be considered a defect. Such a pixel that differs from the reference image, together with adjacent pixels that also differ from the reference image, is considered a single defect. (In an embodiment this may mean a pixel differing from the reference image and which has adjacent pixels which are the same as the reference image (i.e. do not differ from the reference image) can be considered to not represent a defect). The reference image may be obtained in various different ways.

In many cases, the reference image is derived from "live" source images obtained from different parts of the same sample. For example, two source images may be averaged to obtain the reference image. The two source images may be obtained from corresponding regions of different dies of the sample. Alternatively, if the pattern being inspected has a repeating element, the source images may be obtained from the same die. The "live" sources can be obtained using multiple beams or multiple columns to simultaneously image a sample or using one beam or column to image different parts of the sample in quick succession. Either approach can lead to complex scan patterns of the sample relative to the electron-optical column(s). In some cases, whole pattern repeat regions (possibly excluding non-critical regions) are scanned to derive the reference image(s). Thus the reference image(s) are derived before scanning the sample region to obtain the sample image. In other cases, it can be more efficient to scan only a part of each of a plurality of (e.g. two) pattern repeat regions as reference regions and the corresponding part of the pattern repeat region to be inspected (sample region). The sample region and the reference regions are scanned before data processing to detect defects begins and that other parts of the reference regions and sample region are scanned subsequently. In a different embodiment, the sample and reference regions are scanned nearly simultaneously with each other.

Data processing of the detection signal starts as two or more similar portions of at least two regions are scanned. Data processing can therefore be simultaneous with the scanning of the regions, optimally with a minimal time lag. More details of scanning schemes for pattern inspection are described in EP Application 21186705.6 filed on 20 July 2021, which document is incorporated herein by reference, in particular in relation to disclosure of scanning schemes.

The present inventors have determined that the detector 240, which operates at a high temperature due to the heat dissipation of the amplifier and other electronics integrated in it, is a significant cause of temperature gradients in the sample during inspection. These temperature gradients can cause distortion of the sample during inspection in ways that are hard to compensate for either by positional adjustments of the sample during the inspection process or post processing of the obtained image data. This is especially the case where complex scanning patterns are employed to generate images from different parts of the sample for comparison. It is desirable that heat be able to escape from the sample to its surroundings so that a dynamic equilibrium can be established to minimize temperature gradients. It is desirable in some cases that the sample is the hottest object in its surroundings (except for heaters) or is at least as hot as any other object nearby. If the sample is the hottest object, uncontrolled or unpredictable heat flows to it are minimized.

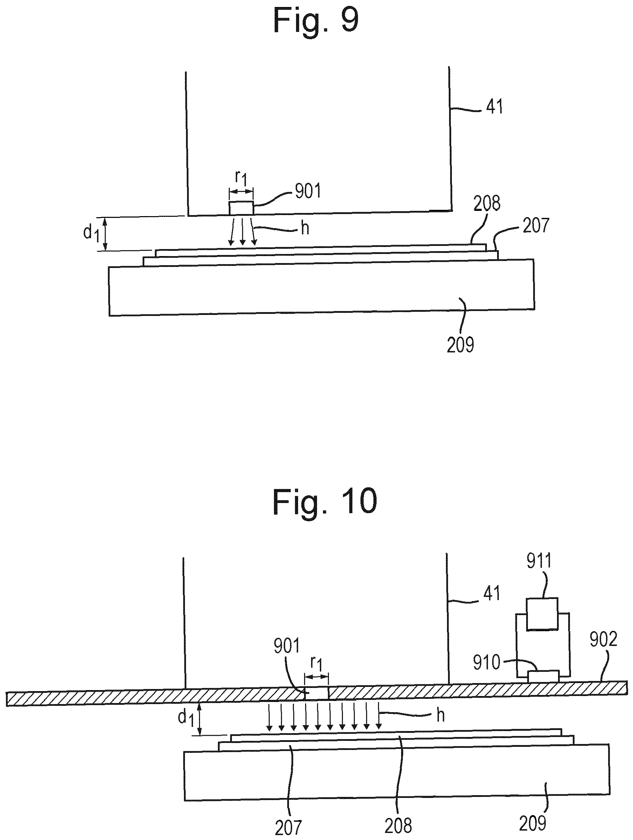

**FIG. 9** depicts schematically the lower part of an electron-optical device 41 facing a sample 208 which is held by a sample holder 207. In turn the sample holder 207 is supported by an actuated stage 209. In the lower part of the electron-optical device 41, e.g. in the sample-facing surface thereof, there is a component 901 which acts as a localized heat source radiating heat to sample 208. Component 901 is referred to herein as a 'hot component' or a thermally elevated component. (Use of the term 'hot component' does not necessarily mean that the component is intentionally thermally elevated, rather use for its intended function causes it to reach a thermally elevated temperature relative to its surroundings. The term 'hot' in the term 'hot component' is therefore a consequence of the component being used for its intended use. The term 'hot component' is therefore intended as a label to indicate that the component during operation is thermally elevated relative to its surroundings.)

For example, the hot component 901 may be a detector module, or part of a detector module. As mentioned above, detector module 240 may include active electronic components such as amplifiers (e.g. trans-impedance amplifiers) analog to digital converters and read out logic. Electronic circuitry, especially active electronic components, dissipates heat in use causing the hot component's temperature to rise. The hot component may be thermally elevated for other reasons. For example heat may be imparted by incidental signal particles emitted by the sample 208. The heat may be difficult to remove from a component in a high vacuum (for example around 1 x 10⁻⁶ mbar), such as present in a vacuum chamber of the electron-optical device, for example without active cooling.

Even if active cooling of the hot component is provided, for example integrated, within the hot component, the hot component may be at an elevated temperature compared to the sample 208. In a practical embodiment, limited space for cooling the hot component is available so that the hot component may operate at a temperature in excess of 100 °C, e.g. about 120 °C to 150 °C. The hot component may be formed on a silicon substrate and during operation of the apparatus emits significant amounts of infrared radiation h towards sample 208.

Hot component 901 is small compared to sample 208. The hot component 901 may have parts thereof that are visible from the position of sample 208 or in a direct line of sight from the surface of the sample. In other words there may be a direct, unobstructed line between the surfaces of the hot component 901 and the sample 208. For example the hot component or such parts with a surface having a direct line to sample surface 208, and capable of radiating heat towards sample 208, may have a largest dimension r₁ in a plane parallel to sample 208 of less than 20 mm, less than 15 mm or about 5 mm. However, larger hot components can still be problematic for example in view of the relative dimension e.g. diameter of the sample 208. The sample 208 may, for example, be a flat disk with a radius of 200 mm, 300 mm or 450 mm. The distance d₁ between hot component 901 and sample 208 is small compared to the size of hot component 901, e.g. less than 2 mm, desirably less than 1 mm, less than 100 µm, and more desirably less than 50 µm. Therefore, the heat that is emitted from hot component 901 is incident on only a small part of sample 208 and thereby causes localized heating of sample 208 in an area similar in size to hot component 901.

As described above, the sample is often moved relative to the electron-optical device in a complex scanning pattern to obtain images of different parts of the sample for comparison in the assessment process. The scanning patterns may also involve significant changes of speed between imaging operations and stepping operations. As a result, a complex and not entirely predictable pattern of temperature variations is created within the sample 208. Simulations by the present inventors have determined that temperature variations within the sample may be of the order of 5 °C or more; noting samples are typically maintained at a temperature of around 20 °C, for example, 19 to 23 °C, such as 22 °C, which temperature may be the standard temperature within a chip fab such as defined by an industry standard. Temperature variations within the sample will cause differential thermal expansion leading to distortion of the sample. The amount of distortion caused by thermal gradients caused by the hot component can be sufficient to distort images obtained for assessment processes and/or to make it difficult to align images that are obtained for comparison purposes. These distortions are difficult to compensate for either in positioning of the sample during the assessment process or in post processing of data obtained from the sample process. The data files corresponding to the images are therefore consequently difficult to process.

In the invention, it is proposed to provide a thermal compensator to supply additional heat to the sample 208 so as to reduce temperature gradients in the sample during the assessment process. It is intended to apply a stable temperature load to the sample, such temperature load including the temperature load applied by the hot component. In the frame of reference of the sample, the heat load experienced by the sample is stable, reducing if not preventing uneven application of a heat load and consequential distortion of the sample. Additional complexity of scanning strategies to mitigate uneven heat loads can be reduced if not avoided because they are unnecessary.

**FIG. 10** depicts a first arrangement of a thermal compensator comprising a radiating member 902 provided adjacent the hot component 901, e.g. surrounding hot component 901 in a plane parallel to sample 208. Radiating member 902 is configured so that in use it is at a temperature higher than the sample 208 and therefore radiates heat h towards sample 208. Therefore, a larger area of sample 208 is heated by the combination of hot component 901 and thermal compensator 902 than by hot component 901 alone. Temperature gradients within sample 208 are therefore reduced.

Desirably, radiating member 902 is significantly larger than hot component 901. In the figure, radiating member 902 is shown as being larger than sample 208, even as large as to cover the whole area of the sample during a complete scan of the sample. Therefore any portion of the sample may be scanned by charged particles and all parts of the sample surface would face the radiating member 902, other than the portion of the sample surface facing the hot component 901. In this embodiment, the radiating component is at least twice the largest dimension (e.g. diameter) of the sample, for example around 600 mm, e.g. 602 mm for a sample of a diameter around 300 mm. However, radiating member 902 does not need to be that large. Desirably, at least the part of the thermal compensator that radiates heat toward sample 208 (in this embodiment radiating member 902) has a dimension r₂ in a plane parallel to sample 208 such that its area is at least five times, more desirably ten times the corresponding area of hot component 901. Most desirably, radiating member 902 is larger than sample 208, even as large as the total area swept by sample 208 during assessment scans. It should be noted that radiating member 902 does not have to be a completely solid body and may be provided with small apertures, such as beam apertures, to allow other components of the apparatus to function. In an embodiment, radiating member 902 may have the form of a grill or mesh.

Several different arrangements can be provided to heat radiating member 902 during operation of the apparatus. A simple arrangement is to provide resistive heaters 910 attached to or embedded within radiating member 902. Resistive heaters 910 can easily be controlled by controller 911 to maintain radiating member 902 at a desired temperature. In an embodiment, the radiating member 902 can itself be a resistive heater, for example current is passed through the radiating member to generate heat. The resistive heater may take the form of an electric element having a circuitous path relative to the radiating member 902, such as within the radiating member 902.

Other forms of heater such as halogen lamps or a supply of heated fluid, can also be employed. For example an embodiment of thermal control using the supply of heated fluid may comprise a thermal conditioned fluid flow such as along a circuitous path in contact with the radiating member 902 for example within the radiating member 902. The radiating member may consist of a material with a sufficiently high heat conductance to have a heat flux through it sufficient to absorb heat at the rate that it radiates. The material may readily emit thermal radiation, desirably substantially of the hot component. This is desirable so the temperature of the radiating member and the hot component is substantially the same. The material may have a melting point that substantially exceeds the operational temperature of the hot component. The material have a high heat capacity.

Desirably the hot component and the radiating member are of the same temperature. However, in an embodiment heat transfer may be encouraged from the hot component 901 to the radiating member 902. Thermal transfer from hot component 901 to radiating member 902 may be encouraged by passive devices such as heat pipes or active devices such as Peltier elements; note the impact of active thermal transfer should be managed with care. For example, Peltier elements risk introduction of unwanted magnetic fields under some operating conditions. Heat pipes may require a notable temperature difference. However, having a common fluid thermal conditioning system with a fluid such as water with a lower temperature than the hot component 901 through hot component 901 and radiating member 902 may be desirable to minimize the thermal difference between the hot component 901 and radiating member 902 if not maintain them at substantially the same temperature. For example the path of the conditioning fluid of the radiating member 902 may be connected to and even comprise the conduits of the thermal conditioning system of the hot component 901. The hot component 901 and radiating member may have the same fluid conditioning system. The thermal conditioning system may regulate the hot component 90, for example to assist the hot component 901 from exceeding a threshold temperature. Desirably the hot component has low emissivity towards the sample however functional requirements of the hot component may limit the choice of materials that it can be made of. Different arrangements can also be combined, in particular combining active heating of radiating member 902 with heat transfer from hot component 901.

It is desirable that radiating member 902 has a temperature as close as possible to hot component 901, e.g. within +/- 5 °C, desirably with +/- 2 °C. However, advantages may be achieved with a greater temperature difference between hot component 901 and radiating member 902 especially if the thermal emissivity characteristics of hot component 901 and radiating member 902 are different. For example, if the emissivity of radiating member 902 is higher than that of hot component 901 an optimum effect may be achieved even if radiating member 902 is at a lower temperature than hot component 901. Conversely, if the thermal emissivity of radiating member 902 is lower than the thermal emissivity of hot component 901 it may be necessary to elevate radiating member 902 to a higher temperature than hot component 901 in order to achieve optimum results. The thermal emissivity of radiating member 902 may be determined by selection of a suitable material and/or surface treatment on the surface(s) facing sample 208.

It is desirable that the spatial variation of the temperature of radiating member 902 is as small as possible, at least in the surface(s) thereof that radiate heat toward the sample 208. However, spatial variations that are small in scale and/or magnitude may not result in temperature variations in the sample 208. Even if spatial temperature variations in the radiating member do result in temperature variations in the sample these may be acceptable if smaller than the temperature variations that would arise if the thermal compensator were absent. This is a desirable outcome in having the thermal compensator, e.g., the radiating member 902.

Similarly, it is desirable that the temporal variation of the temperature of radiating member 902 is as small as possible, at least in the surface(s) thereof that radiate heat toward the sample 208. However, temporal variations that are small in scale and/or magnitude may not result in temperature variations in the sample 208. Even if thermal temperature variations in the radiating member do result in temperature variations in the sample these may be acceptable if smaller than the temperature variations that would arise if the thermal compensator were absent. This may be a desirable outcome in having the thermal compensator, e.g., the radiating member 902. Before scanning of the sample occurs, a portion of the sample to be scanned is in substantial thermal equilibrium with respect to the heat load applied by the hot component during scanning. Distortion of the sample surface is avoided due to thermal imbalances in sample surface around the time of scanning by the charged particle beam.

In some cases, it may be desirable to deliberately introduce a temporal variation in the temperature of the radiating member 902. For example, it may be desirable to reduce the temperature of the radiating member progressively during a long assessment process in order to limit the total heat load on the sample 208. Alternatively or in addition, if the hot component 901 is relatively cold at the beginning of an assessment process, e.g. because it is off and cools down during exchange of samples, it may be desirable for the radiating member to also be initially cool and rise in temperature similarly to the hot component 901. Therefore in an embodiment the radiating member is thermally controlled to match the radiative thermal load density (i.e. radiative thermal load per unit area) emitted towards the sample by the hot component.

The assessment system may have a plurality of hot components 901: e.g. if the assessment system is a multi-beam system optionally having a detector for each beam; if the assessment system has multiple detectors per beam; or if the assessment system is a multi-column system having a single beam or a plurality of beams per column, each column optionally having a detector or detector array facing the sample; or if multiple different types of component are hot during operation, for example that face the sample during operation. Depending on the locations of the hot components 901, one or more radiating members 902 may be provided. For example, a single radiating member may be provided for several hot components that are close together but separate radiating members may be provided for hot components or groups of hot components that are farther apart. The larger the number of sub-beams in a multi-beam (such as more than 5, more than 10 or more than 20), the larger the field of view of the multi-beam on the sample surface and the larger the footprint of the multi-beam is on the sample surface. A electron-optical device or column with a larger field of view is likely to have a larger dimension, such as a diameter of hot component. The larger the hot component or group of hot components, the more likely that a single radiating member 902 is provided. If the electron beam system is a multi-column system, there may be: multiple radiating members per column; one radiating member per column; one radiating member for multiple columns; or one radiating member for all columns.

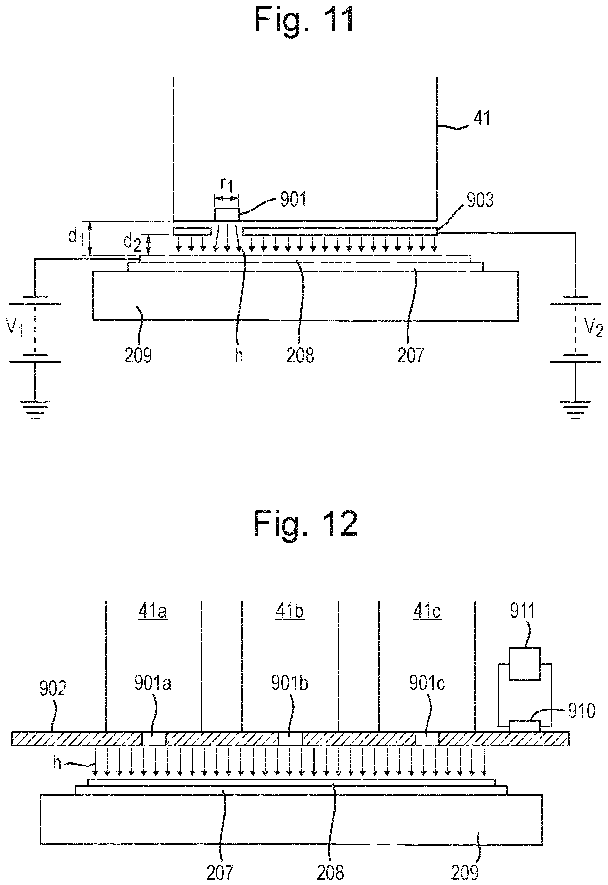

**Fig. 12** depicts an arrangement for a multi-column apparatus having a single radiating member 902 in which is defined an aperture for the respective hot components 901a-901c of respective electron-optical devices 41a - 41c. Although a single heater 910 is shown in the figure, multiple heaters may be provided at different places on the radiating member to ensure a uniform temperature profile. Optionally the single radiating member 902 comprises a plurality of radiating elements of which a least one associated with a respective device of the multi-column array.

Radiating member 902 may be combined with another component of the assessment system, i.e. the radiating member performs multiple functions. For example the radiating member may be a structural component that supports another component, desirably thermally isolated from other components for example of the stage, electron-optical device 41, and a frame arranged to support, for example, the radiating member, the electron-optical device 41 and metrological components for example for alignment and alignment of a sample on the sample holder to the electron-optical device 41. In another example, the radiating member may be combined with the function of a protective plate, as shown in **FIG. 11****.**

Combined radiating member and protective plate 903 is connected to a voltage source V₂ and may also be referred to as a high-voltage plate. The potential applied to the high voltage plate may correspond to around the maximum potential difference in the electron-optical device, for example 20, 30, or even 50 kV relative to a reference potential such as a ground potential. The potential of the high voltage plate may the same or substantially the same (except for accounting for a small offset of a magnitude of around 50V to 5kV for example dependent on the design of the electron-optical device 41) potential relative to the reference potential as the sample. The purpose of the high voltage plate is to ensure that the electric field near the sample (which is set to a similar potential) is small if not negligible. In a different embodiment the sample is set to at or close to ground and the protective plate 903 still has a common voltage except it is a low voltage plate having an off-set of about 50V to 200 V relative to the potential of the sample. In this arrangement of electron-optical device, the maximum potential difference is still 20, 30, or even 50 kV relative to the reference potential (such as that of the sample) to achieve a similar electron-optical performance, Such an electron-optical device is described in EP Application 21199203.7 filed on 27 September 2021, which is incorporated by reference so far as the disclosure of an electron-optical architecture used to achieve having the sample set to a ground potential with a large maximum potential difference between elements of the electron-optical column such as between the source and the sample.

The combined radiating member and protective plate 903 is referred to below as the protective plate 903 for the sake of brevity. It may be configured to provide a clearly defined and constant electrical field between the protective plate 903 and the sample 208 which is held at a potential V₁. The protective plate 903 may have a flat surface facing the sample 208. The protective plate 903 may electrically shield the sample 208 from irregularities such as protrusions or holes provided above the protective plate 903 (e.g. for mechanical reasons). An objective lens array 241 may be at least partially shielded by the protective plate 903 from electric fields generated during the drawing of particles away from the surface of the sample 208 and/or stage 234 by a particle trap. Further details of the protective plate and particle trap may be found in copending application EP Application 21166211.9 filed 31 March 2021, which document is hereby incorporated by reference at least in respect of the description of a protective plate and particle trap.

The distance d₂ between protective plate 903 and sample 208 may be less than the distance d₁ between hot component 901 and sample 208 and this may be taken account of in determining the desired temperature profile of the protective plate 903. Although the protective plate 903 is as having a similar area to the bottom of electron-optical device 41, it may be bigger or smaller than that. In an arrangement the detector module may be mounted in or on the protective plate. That is the protective plate may perform three functions: supporting the detectors or other components, controlling the electric field above sample 208, and radiating heat to sample 208 to reduce temperature variations therein.

Another approach to reducing temperature gradients in the sample 208 during an assessment process is to provide a temperature compensator that is configured to preheat the sample to a temperature higher than the ambient temperature of the assessment system and surrounding environment (e.g. the clean room). The temperature of a clean room for semiconductor manufacture may be kept within a very close range of a predetermined setpoint in the range of, for example, 19 to 23 °C. Desirably the sample is preheated to a temperature of 25 °C or higher. The sample may be heated towards a temperature of the hot component 901 during operation so that the sample can be retained and maintained at a stable temperature during operation of the electron-optical device 41. In a thermal context, the rate of the radiative heat input into the sample equals the rate of conductive heat output out of the sample. Pre-heating of the sample reduces temperature gradients that would otherwise be caused by the hot component because a relatively hot sample will not absorb as much heat from the hot component as would a relatively cold sample. The sample can be maintained in a thermal equilibrium while it is clamped to the sample support.

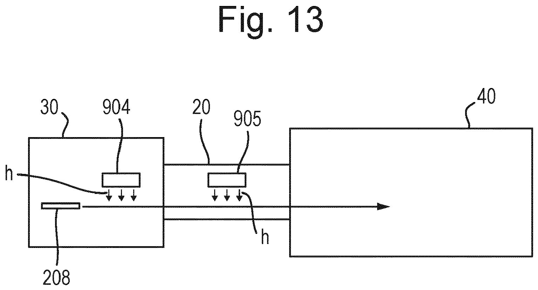

An example of this approach is depicted in **FIG. 13** which depicts schematically the load path of a sample from the EEFM 30, load lock chamber 20 to electron beam system 40. The temperature compensator comprises one or more heating devices located proximate to the load path and arranged to heat a sample on the load path. For example a heater 904 may be provided in EEFM 30 and/or a heater 905 may be provided in load lock chamber 20. Any convenient type of heater may be used, such as resistive heaters attached to radiating members or halogen lamps, for example as described with reference to the radiating member 902. In parts of the system that are under vacuum, radiative heaters are preferred. In parts of the system that have a significant gas pressure, convection may be employed to transfer heat to the samples. The samples may be heated from either or both sides.

It is desirable that heating the sample does not decrease throughput. Thus the desired level of heating should be achieved in parallel with other processes applied to an incoming sample or during any idle time of an incoming sample whilst the preceding sample is being inspected. Heaters of suitable power to achieve sufficiently quick heating should therefore be selected.

It is desirable that the sample holder 207 is also pre-heated before the sample is clamped to it. The sample holder is desirably pre-heated to the same temperature as or a similar temperature to the sample 208. The sample holder 207 can be pre-heated with the same thermal conditioner, such as the heater as used to pre-heat the sample 208, or by an additional thermal conditioner such as an additional heater for example provided in or on the surface of the sample holder 207 for supporting a sample and/or under the sample holder 207. The sample holder may consist of a material with a suitable heat conductance to distribute the heat provided by the additional thermal conditioner. The sample holder 207 may comprise or consist of ceramic.

The load lock chamber 20 may have a load lock system which includes a plurality of supporting structures configured to support a sample and a first conditioning plate. The first conditioning plate includes a first heat transfer element configured to adjust a temperature of the sample. The load lock system also includes a first gas vent configured to provide a gas between the first conditioning plate and the sample. Furthermore, the improved load lock system includes a controller including a processor and a memory. The controller is configured to assist with control of the first heat transfer element. Such a load lock system is disclosed in more detail in US 2020/0027763 A1, which document is incorporated by reference at least in relation to the disclosure of a load lock system. In the known use of the load lock system, the first heat transfer element is controlled by the controller to bring the samples that are loaded in to the assessment system up to a desired temperature, e.g. 22 °C, which is the same as the temperature of the sample holder 207. This speeds up processing of samples by reducing the time required for the sample and sample holder to reach thermal equilibrium. It also increases accuracy by reducing distortion that might be caused by expansion of the sample as it comes to thermal equilibrium with the sample holder whilst clamped to the sample holder.

In the present invention, the load lock system is used, for example repurposed, to heat the sample to a higher temperature (as discussed above) in order to reduce temperature gradients that would otherwise occur due to a hot component radiating heat to the sample during the assessment process.

The sample holder 207 may take the form of an electrostatic chuck in which the sample is clamped to the sample holder by electrostatic forces. Further details of such electrostatic chucks are disclosed in WO 2021185939 and WO2020126963, which documents are incorporated herein by reference at least in relation to the disclosure of electrostatic chucks.

The inventors have determined that preheating of the sample, and optionally the sample holder, to a higher temperature than is conventional, e.g. heating to a temperature greater than 25 °C, as discussed above has an additional benefit of reducing a problem of "slipstick". Slipstick occurs when there is a sudden and temporary loss of clamping force between the sample and sample holder so that at least a portion of the sample moves relative to the sample holder. The sample typically re-clamps to the sample holder. Despite the sample being securely supported by the sample holder, the position of the sample relative to the sample holder has moved. The sample is now misaligned and requires realignment for scanning, e.g. assessment, to continue.

A cause of slipstick is a temperature change of the sample whilst the sample is clamped to the sample holder so as to cause expansion or contraction of the sample relative to the sample holder. When relative expansion or contraction occurs, stresses arise in the sample and/or sample holder. If those stresses are too high, the sample may move relative to the sample holder, for example suddenly and spontaneously, so that the stresses are alleviated or at least reduced. This movement may be a global movement of the whole sample or a local movement if there are temperature gradients in the sample. Such a slipstick movement may comprise a linear component of relative movement between the sample and the sample holder. The slipstick movement may comprise a rotational movement relative to the sample holder. Relative movement of the sample and sample holder whilst the sample is clamped can generate particles, which is undesirable.

Pre-heating of the sample may be advantageous therefore even where there is no hot component, or the distortion caused by the hot component is not problematic. In such a situation there is a dynamic heat flux experienced by the sample. The heat load applied to the sample may not be as great as by the hot component but other heat sources such as from an incident charged particle beam may input heat into the sample. The sample will also experience a heat output for example towards the sample holder. This is thus a similar thermal situation as an arrangement with a hot component.

Such pre-heating to at least reduce the risk of slipstick may occur prior to loading of the sample onto the sample holder 207. However, after loading of the sample 208 on the sample holder, the previously known pre-heating elements can no longer maintain thermal conditioning (e.g. heating) of the sample. In an embodiment, the radiating member 902 may be present up-beam of the sample holder 208. The radiating member may face the position of the sample on the sample holder 207. The radiating member 902 and optionally the hot component 901 (if present) may be operated to radiate heat towards the position of the sample that the sample 208 will take when supported by the sample holder 207. Thus as the sample holder is loaded onto the sample holder 207, the thermal conditioning of the sample can be maintained. Thus the application of heat to the sample 208 may be maintained despite the cessation of the preheating of the sample after it has left the EFEM 30 and the sample handler 20, respectively. By maintaining the thermal conditioning, for example the elevated temperature of the sample as it is loaded on the sample holder the sample does not distort. Stress build-up in the sample is avoided.

The radiating member 902 (and optionally the hot component 901) may be operated to radiate heat towards the sample 208 as it is secured, for example clamped, to the sample holder. Clamping of the sample to the sample holder is desirably achieved with high thermal conductance from sample towards the sample holder. Desirably the sample holder comprises a material of high thermal conductance. Clamping the sample to the sample holder with high thermal conductance to the sample holder helps to ensure that the sample temperature remains minimally elevated relative to its immediate surrounding such as the sample holder. Stress build-up in the sample is avoided reducing the risk of slipstick. This is especially the case if the radiating element is required to operate to compensate for the thermal load applied to the sample during operation of the hot element for example during scanning, e.g. assessment, of at least a portion of the sample surface.

Thus by preheating to a certain temperature at which the sample will experience a heat rate input that is substantially similar to the rate of the heat output by the sample and clamping the sample at that temperature, the sample may be held securely with a reduced risk of slipstick. At the certain temperature the temperature of the sample is substantially stable. Thus pre-heating may adjust the sample to the stable temperature so that the sample has the same temperature at and during clamping as during operation for example of the charged particle device 41.

The controller 50 may be operated to control the pre-heating of the sample in the EFEM 30 and the sample handler 20 with the radiating member 902 (and optionally the hot component 901) so that the sample is thermal conditioned, e.g. preheated, so it remains above a threshold temperature. The sample may be controlled to remain above the threshold temperature until at least clamping of the sample, for example, until assessment of the sample has commenced. Thermal conditioning of the sample by the radiating member 902 may start at least from support of the sample 208 by the sample holder for example at least from contact of the sample 208 by pins of the sample holder used to lower and elevate the sample from the surface of the sample holder 207. In an embodiment thermal conditioning of the sample 208 starts as the sample approaches the sample holder from the load lock 20. The threshold temperature may be elevated relative to a predetermined setpoint in the range of, for example, 19 to 23 °C. Desirably the sample is preheated to a temperature of 25 °C. The controller 50 may be configured to control the heater in each of the EFEM 30, the load lock chamber 20, the radiating member 902 and optionally the hot component 901.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down-beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam-limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample, for example in response to scanning the sample surface with one or more beams of electrons. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle-optical device) may be a component of an assessment tool, such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a charged particle-optical device may more specifically be defined as a charged particle-optical device. In other words, the device may be provided as a column. The device may thus comprise an objective lens array assembly as described above. The device may thus comprise a charged particle optical system as described above, for example comprising an objective lens array and optionally a detector array and/or optionally a condenser lens array. Optionally the charged particle device may comprise a source. The charged particle device may be a part of an charged particle apparatus. Such a charged particle apparatus comprises the charged particle device and a source (if not part of the charged particle device) and an actuatable stage for supporting the sample. The actuatable stage may be actuatable to move the sample relative to the paths of the charged particles from the device. The charged particle apparatus may be locatable on the footprint in the chip fabrication facility. A charged particle system may comprise the charged particle apparatus and environmental conditioning systems and processors such as process racks which may be remote from the part of the system present on the apparatus footprint. Such environmental conditioning systems way comprises parts of a thermal conditioning system and part of a vacuum system.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

The term "image" used herein is intended to refer to any array of values wherein each value relates to a sample of a location and the arrangement of values in the array corresponds to a spatial arrangement of the sampled locations. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Aspects of the invention are set out in the following numbered clauses.
Clause 1: A charged particle assessment apparatus comprising: a charged particle beam device; an actuated sample stage configured to hold a sample; a hot component configured to operate such that, during operation, heat is radiated toward a sample held on the sample holder, the hot component being smaller than the sample; and a thermal compensator configured to heat the sample so as to reduce thermal gradients therein.
Clause 2: A charged particle assessment apparatus according to clause 1, wherein the hot component comprises an electron-optical component, desirably a detector module, desirably the charged particle beam device is configured to project a plurality of charged particle beams desirably through the hot component.
Clause 3: A charged particle assessment apparatus according to clause 2, wherein the detector module includes electric circuitry, such as an active electronic component, e.g. an amplifier and/or an analog to digital converter.
Clause 4: A charged particle assessment apparatus according to clause 2 or 3, wherein the hot component comprises the detector module configured to detect signal particles from the sample, wherein the detector module desirably comprises an array of detector elements and the charged particle beam device is configured to direct a plurality of sub-beams towards the sample desirably the charged particle beam device is configured to direct the beams towards the sample, desirably each detector element corresponding to one or more of the beams.
Clause 5: A charged particle assessment apparatus according to any preceding clause having a plurality of hot components.
Clause 6: A charged particle assessment apparatus according to any preceding clause, wherein the or each hot component has a largest dimension in a plane parallel to the sample that is less than 30 mm, desirably less than 20 mm.
Clause 7: A charged particle assessment apparatus according to any of the preceding clauses wherein the hot component is at a temperature greater than 80 °C, greater than 100 °C, or greater than 120 °C, during operation of the system.
Clause 8: A charged particle assessment apparatus according to any of the preceding clauses wherein the hot component is, during operation of the system, proximate the sample, e.g. at a distance from the sample of less than 2 mm, desirably less than 1 mm, more desirably less than 100 µm.
Clause 9:A charged particle assessment apparatus according to any of the preceding clauses wherein the thermal compensator comprises a radiating member.
Clause 10: A charged particle assessment apparatus according to clause 9 wherein the area of the radiating member that radiates heat to the sample is at least 5 times, desirably at least 10 times, the area of the hot component that radiates heat to the sample.
Clause 11: A charged particle assessment apparatus according to clause 9 or 10 wherein the area of the radiating member that radiates heat to the position of the sample is greater than the area of the sample.
Clause 12: A charged particle assessment apparatus according to any of clauses 9 to 11, wherein the surface of the radiating member facing the position of the sample has an emissivity in the range of from 80% to 120%, desirably from 90% to 110%, of the emissivity of the surface of the hot component facing the position of the sample.
Clause 13: A charged particle assessment apparatus according to any of clauses 9 to 12, wherein the radiating member is proximate the hot component, desirably surrounding the hot component in a plane parallel to the sample.
Clause 14: A charged particle assessment apparatus according to any of clauses 9 to 13, further comprising a temperature control system, wherein the temperature control system is configured to maintain the radiating member at a temperature greater than the sample during operation of the system.
Clause 15: A charged particle assessment apparatus according to any of clauses 9 to 14 wherein the temperature control system is configured to maintain the radiating member within a temperature range of ±10 °C, desirably ±5 °C, of the temperature of the hot component.
Clause 16: A charged particle assessment apparatus according to any of clauses 9 to 15 wherein the temperature control system comprises a resistive heater.
Clause 17: A charged particle assessment apparatus according to any of clauses 9 to 16, wherein, in operation, the distance between the radiating member and the sample is in the range of from 80% to 120%, desirably from 90% to 110%, of the distance between the hot component and the sample.
Clause 18: A charged particle assessment apparatus according to any of clauses 9 to 17, further comprising a voltage source electrically connected to the radiating member and configured to set the radiating member to a predetermined potential.
Clause 19: A charged particle assessment apparatus according to any of the preceding clauses wherein the thermal compensator comprises a halogen lamp.
Clause 20: A charged particle assessment apparatus according to any of the preceding clauses wherein the thermal compensator comprises a heating device configured to heat the sample before it is loaded onto the sample stage.
Clause 21: A method of assessing samples using a charged particle beam apparatus, the method comprising: scanning a sample held on an actuated sample stage relative to a charged particle beam and detecting charged particles returning from the sample, wherein a hot component of the charged particle beam system radiates heat locally to the sample during the scanning; and heating the substrate to reduce thermal gradients therein.
Clause 22: A method of loading a sample into a charged particle beam apparatus, the method comprising: heating a sample prior to the sample being supported by a sample support of the charged particle beam apparatus; loading the sample onto the sample support; and maintaining the temperature of the sample above a threshold temperature during the loading.
Clause 23: The method of clause 22, wherein the maintaining comprises transferring the thermal conditioning of the sample from a heating device to a thermal compensator, wherein thermal conditioning of the sample comprising: desirably thermal conditioning of the sample by the heating device prior to the loading of the sample onto the sample support; and desirably thermal conditioning of the sample by the thermal compensator when on the sample support, desirably the thermal compensator directing heat towards the position of the sample.
Clause 24: The method of clause 23, wherein the heating device is operational prior to loading of the sample, desirably when the sample is in a sample handler comprised in the charged particle beam system.
Clause 25: The method clauses 23 or 24, wherein the thermal compensator directs heat towards the sample so as to reduce thermal variations therein generated by a hot component comprised in the particle assessment system.
Clause 26: The method of any of clauses 22 to 25, wherein the threshold temperature during the loading is above the ambient temperature, for example more than 22 degrees (e.g. 25 degrees).
Clause 27: The method of any of clauses 22 to 26, wherein the sample is maintained at at least the threshold temperature until an assessment process is complete.
Clause 28: The method of any of clauses 22 to 27, wherein the loading at least comprises clamping of the sample to the sample support.
Clause 29: The method of any of clauses 22 to 28, further comprising heating the sample support prior to loading the sample thereon.
Clause 30: A particle assessment apparatus comprising: a particle beam device; an actuated sample support configured to support a sample; a hot component that is configured to radiate heat toward a sample supported on the sample support during operation of the system; a thermal compensator proximate the particle beam device and configured to direct heat towards the sample so as to reduce thermal gradients therein generated by a thermally elevated component; a heating device configured to heat the sample before the sample is supported by the sample support; and a controller configured to control at least the thermal compensator and the heating device so that the temperature of the thermal compensator is at least maintained above a threshold temperature while the sample is loaded, desirably clamped, onto the sample support.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged particle assessment apparatus comprising:
a charged particle beam device;
an actuated sample stage configured to hold a sample;
a hot component configured to operate such that, during operation, heat is radiated toward a sample held on the sample holder, the hot component being smaller than the sample; and
a thermal compensator configured to heat the sample so as to reduce thermal gradients therein.

2. A charged particle assessment apparatus according to claim 1, wherein the hot component comprises an electron-optical component.

3. A charged particle assessment apparatus according to claim 2, wherein the electron-optical component is a detector module,.

4. A charged particle assessment apparatus according to claim 3, wherein the detector module includes electric circuitry, such as an active electronic component.

5. A charged particle assessment apparatus according to claim 3 or 4, wherein the hot component comprises the detector module configured to detect signal particles from the sample, wherein the detector module desirably comprises an array of detector elements and the charged particle beam device is configured to direct a plurality of sub-beams towards the sample.

6. A charged particle assessment apparatus according to any preceding claim having a plurality of hot components.

7. A charged particle assessment apparatus according to any of the preceding claims wherein the hot component is, during operation of the system, proximate the sample.

8. A charged particle assessment apparatus according to any of the preceding claims wherein the thermal compensator comprises a radiating member.

9. A charged particle assessment apparatus according to claim 8 wherein the area of the radiating member that radiates heat to the sample is at least 5 times the area of the hot component that radiates heat to the sample.

10. A charged particle assessment apparatus according to claim 8 or 9 wherein the area of the radiating member that radiates heat to the position of the sample is greater than the area of the sample.

11. A charged particle assessment apparatus according to any of claims 8 to 10, wherein the surface of the radiating member facing the position of the sample has an emissivity in the range of from 80% to 120%of the emissivity of the surface of the hot component facing the position of the sample.

12. A charged particle assessment apparatus according to any of claims 8 to 11, wherein the radiating member is proximate the hot component.

13. A charged particle assessment apparatus according to any of claims 8 to 12, further comprising a temperature control system, wherein the temperature control system is configured to maintain the radiating member at a temperature greater than the sample during operation of the system.

14. A charged particle assessment apparatus according to any of claims 8 to 13, further comprising a voltage source electrically connected to the radiating member and configured to set the radiating member to a predetermined potential.

15. A charged particle assessment apparatus according to any of the preceding claims wherein the thermal compensator comprises a heating device configured to heat the sample before it is loaded onto the sample stage.
